Europäisches Patentamt

(19) European Patent Office

Office européen des brevets

(11) Publication number : **0 339 845 B1**

## EUROPEAN PATENT SPECIFICATION

(12)

(45) Date of publication of patent specification :
07.01.93 Bulletin 93/01

(51) Int. Cl.⁵ : **G01B 11/06**

(21) Application number : 89303759.8

(22) Date of filing : 17.04.89

(54) **System for automated real-time control of film deposition.**

(30) Priority : 29.04.88 US 188524

(43) Date of publication of application :
02.11.89 Bulletin 89/44

(45) Publication of the grant of the patent :
07.01.93 Bulletin 93/01

(84) Designated Contracting States :
DE FR GB NL

(56) References cited :
EP-A- 0 102 470
FR-A- 2 023 764
JP-A- 1 107 519
JP-A-61 194 835
IBM TECHNICAL DISCLOSURE BULLETIN,
vol. 25, no. 1, June 1982, pages 436-438, New
York, US ; G.H. HEWIG et al.: "In-situ,real-time
thin-film refractive index and thickness moni-
tor"

(73) Proprietor : Hughes Aircraft Company
7200 Hughes Terrace P.O. Box 45066
Los Angeles, California 90045-0066 (US)

(72) Inventor : Smith, Ronald T.
320 Paseo Dela Play Redondo Beach
California 90277 (US)
Inventor : Yee, Edward M.
17166 Miss Grace Drive Canyon Country
California 91351 (US)
Inventor : Linder, Jacques F.
27151 Pembina Road Palos Verdes
California 90274 (US)
Inventor : Chern, Mao-Jin
28414 Seamount Drive Rancho Palos Verdes
California 90274 (US)
Inventor : Fisher, Gary
2059 West 146th Street Gardena
California 90249 (US)

(74) Representative : Colgan, Stephen James et al
CARPMAELS & RANSFORD 43 Bloomsbury
Square
London WC1A 2RA (GB)

## Description

BACKGROUND OF THE INVENTION

The present invention relates to the field of deposition of layers on a substrate, and more particularly, to a novel system for computer-controlled real-time monitoring and feedback control of deposition of films possessing an arbitrary refractive index profile.

In various optical systems, it is often necessary to provide a filter in order to remove undesired radiation while at the same time allowing desired radiation to be efficiently transmitted or reflected. One such filter is the reflective multiple layer dielectric filter. U.S. Patent 4,545,646, assigned to the same assignee as the present application, discloses a process for forming a graded index optical material which is useful for fabricating optical structures such as diffraction optical elements. One embodiment discussed in that patent employed manual manipulation of the gas flow to produce an oxide film with a refractive index that varied in a continuous sinusoidal pattern.

Conventional deposition monitoring techniques have employed real-time monitoring of the deposited film index and/or the deposited film thickness using various instruments, such as the reflectometer or the quartz crystal monitor, and a human operator manually controlling the deposition in response to the monitored data.

One technique which has been employed in the past to monitor the thickness of films deposited on substrates employs individual witness wafer chips. The chips are stacked in a magazine and dispensed individually during the deposition process by stopping the process, removing the used witness chip, positioning a fresh one, and continuing the deposition process. A commercial system employing individual witness chips is the 939 chip changer marketed by Dyn-Optics, 23055 Alcade Drive, Laguna Hills, California.

The use of individual wafer chips to monitor the deposition process is cumbersome and time consuming, and leads to deposition measurement errors, as a result of the repetitive handling of the chips.

Furthermore, optical monitoring systems employing individual wafer chips are usually used to deposit multilayer films consisting of relatively thick individual layers of uniform refractive index. This monitoring technique is not suited to deposition of a graded index film, because the rapidly varying deposited refractive index requires changing wafer chips after only a thin film has been deposited on each chip. However, conventional optical monitoring techniques such as reflectometry are not able to measure thin films accurately.

The quartz crystal monitoring technique requires knowledge of the density of the deposited film, which varies as a function of refractive index. In a multilayer film where there are only two or three materials and indices used, the quartz crystal monitoring technique works well. However, in a graded index film where the material density is continually changing, it is very difficult to keep track of this changing density. As a result, it is difficult to accurately monitor the deposition of graded index films using a quartz crystal monitor.

EP-A-0102470 discloses an ellipsometer system for measuring the thickness of a film as it is being deposited on a substrate in a furnace. A laser beam is projected through the furnace window onto a wafer sample which reflects the beam onto a second wafer and then out of the furnace to a beam splitter which splits the beam into two orthogonally polarised beams from which the film thickness can be determined.

It would therefore represent an advance in the art to provide a system for automatic deposition of a filter having an arbitrary refractive index profile which does not require human intervention and which is able to accurately monitor the deposition of graded index films.

It would further be advantageous to provide a deposition system which allows automatic monitoring and feedback control of a deposition without human intervention.

It would represent a further advance in the art to provide a system allowing accurate monitoring of film of arbitrary thickness and index profile.

According to the invention, there is provided a system for automated control of the deposition of a film onto a substrate, comprising: a deposition reactor; means for depositing a given material or materials on one or more substrates disposed within said reactor in dependence on one or more deposition control variables; means for measuring the thickness of the film as it is deposited, said means comprising; (i) a witness wafer disposed in said reactor; (ii) an ellipsometric measuring device for successively measuring the thickness of the film as it is being deposited on said wafer in real time and without removing said wafer from the deposition reactor and without disturbing said depositing means; and (iii) means for providing a film thickness signal indicative of the film thickness; central controller for automated control of said depositing means and said measuring means, said controller comprising means responsive to said film thickness signal for determining the thickness of the film and means for controlling said deposition control variables to effectively control said depositing means; characterised in that: said measuring means further comprises a witness wafer mask arranged to mask the top surface of said witness wafer from the material deposition, said mask having an opening formed therein, and means for moving said witness wafer in response to wafer movement commands from said central controller so as sequentially to expose non-deposited areas of said wafer surface; and said controller further comprises means for providing said wafer movement commands so as freshly to expose a non-deposited area on said witness wafer when the thickness of the film layer on the wafer area presently exposed to the deposition process exceeds a predetermined film layer thickness. In the disclosed embodiment, the material deposition is by a photochemical vapor deposition process. For this embodiment, the depositing means includes reactant and purge gas sources, valves and mass flow controllers for controlling the flow of gases into the reactor, and a vacuum system for evacuating the gases within the reactor.

Preferably, the witness wafer is mounted on a turntable for rotational movement, with a moveable axis for translation movement. The mask has the opening formed in it so that only the surface of the wafer disposed directly beneath the opening is exposed to the material deposition. The turntable is driven by two stepper motors to allow selective successive exposure of fresh areas of the wafer surface to the material deposition.

In the disclosed embodiment the central controller is a computer including a memory for storing the desired specifications of the film to be deposited on the substrate. A typical example of an article to be fabricated by the deposition process is an optical filter, and the memory includes data defining the specifications of such a filter. By commanding the measuring means to make successive measurements of the film thickness as it is being deposited, the central controller can adjust the deposition control variables to compensate for deposition thickness errors and obtain an optical structure having the desired characteristics. In a photo CVD process, the continuously variable refractive index material is approximated by a plurality of successive, constant-index layers, the thickness of each layer is monitored and controlled.

These and other features and advantages of the present invention will become more apparent from the following detailed description of an exemplary embodiment thereof, as illustrated in the accompanying drawings, in which:

FIG. 1 is a block diagram of a controller system for automated real-time control of a deposition process in accordance with the invention.

FIG. 2. is a cross-sectional view of the witness wafer, wafer turntable and mask arrangement employed in the embodiment of FIG. 1.

FIG. 3 is a representative plot of an exemplary desired refractive index profile (solid line) and an approximation thereof (dashed line) as a function of film thickness.

FIG. 4 is a broken-away view illustrating the deposition reactor and placement of the ellipsometer heads of the system shown in FIG. 1.

FIG. 5 is a top view of the witness wafer mask of the embodiment of FIG. 1, illustrating a presently exposed wafer area being illuminated by the ellipsometer laser and two exemplary previously deposited spots.

FIG. 6 is a graph plotting the deposition rate and refractive index as a function of the film thickness for an exemplary optical structure to be fabricated by the system of FIG. 1.

FIG. 7 is a graph plotting the intended and actual refractive index profile as a function of film thickness for the example of FIG. 6.

FIG. 8 is an exemplary plot of an intended and an actual refractive index profile for an exemplary optical structure as a function of film thickness, which is fabricated by a system in accordance with the present invention which employs both refractive index and thickness monitoring and control.

FIG. 9 is a simplified flowchart of the operation of the computer controller of FIG. 1 during fabrication of a typical optical structure.

FIGS. 10A and 10B are simplified flowcharts illustrating the film deposition subroutine employed in the general flowchart of FIG. 9.

## DETAILED DESCRIPTION OF THE DISCLOSURE

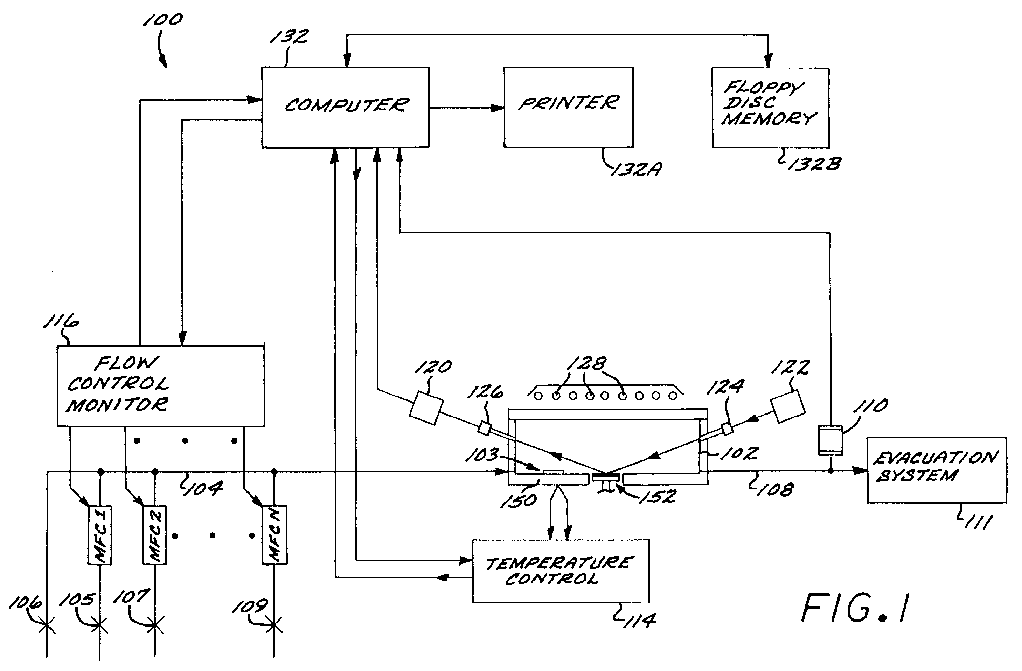

The invention comprises a system for computer-controlled, real-time monitoring and control of the deposition of films possessing an arbitrary refractive index profile. The embodiment of the invention illustrated in FIG. 1 employs an ellipsometer as the monitoring instrument and a moving witness wafer as a means of data sampling. In this example, the photochemical vapor deposition process described in U.S. Patent 4,545,646, is employed as the deposition process. With this process, by varying the ratio of silane to nitrous oxide flow rate accordingly throughout the deposition, a film possessing an arbitrary, predetermined index profile may be deposited. However, it is to be understood that the control system described herein is not limited to use with photochemical vapor deposition processes but may be applied to a wide variety of deposition processes.

The system 100 of FIG. 1 employs an ellipsometer which measures the thickness of a growing film on a witness wafer 158 placed in close proximity to the main substrate 103 on which the desired layer is to be deposited. A mask is disposed over the witness wafer, and the mask has an opening formed therein large enough to permit deposition on the exposed spot of the wafer and ellipsometric measurement of the resultant film (FIG.

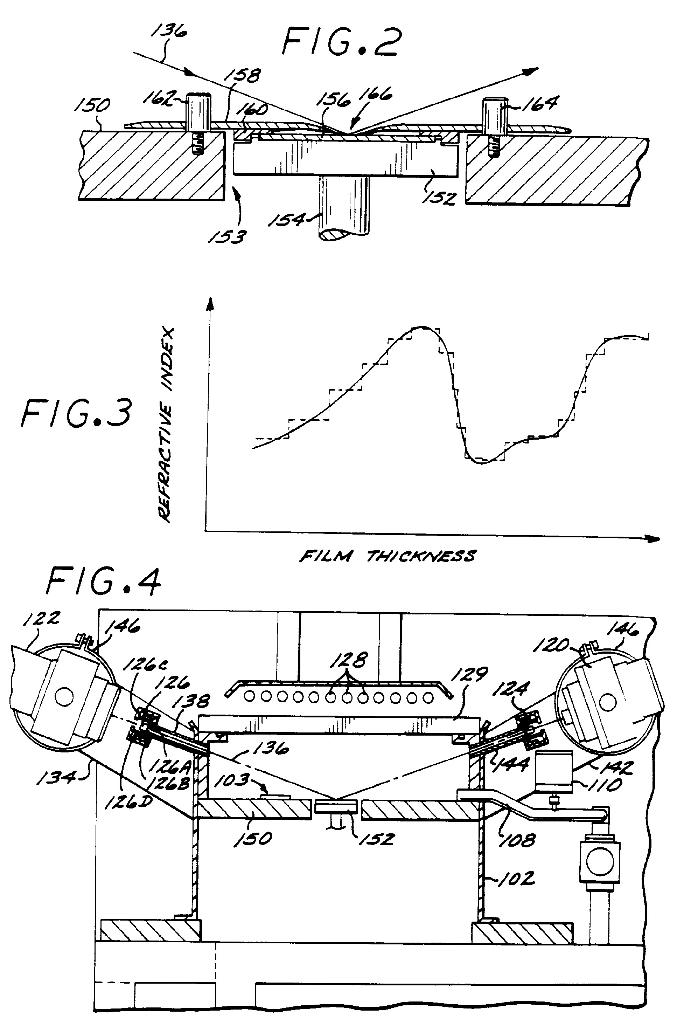

2) Although the deposited film may have a graded refractive index profile, over sufficiently small thickness increments, the graded profile segment may be approximated as a constant-index film, as shown in FIG. 3. Therefore, the film on a particular spot of the witness wafer is ellipsometrically measured, a certain constant refractive index corresponding to the gas flow rates is assumed, and a thickness is calculated, which is a valid approximation for thin films. When the film has reached a certain thickness, the witness wafer is rotated so that a fresh spot on the substrate is exposed to deposition. In this manner the entire deposition can be monitored segment-by-segment.

In general, the system 100 (FIG. 1) comprises a deposition reactor 102 into which reactant and purge gases may be admitted through line 104 by respective valves 105, 107 and 109, and mass flow controllers MFC1-MFCN and valve 106. Preferred purge gases for this embodiment include nitrogen or argon. The reactant gases include silane and nitrous oxide. A commercial embodiment of a mass flow controller suitable for the purpose is the model UFC 1000 controller, marketed by Unit Instruments, Inc., 1247 W. Orange Avenue, Orange, California.

A flow control monitor 116 is coupled to the mass flow controllers MFC1-MFCN to monitor and control the flow of the respective reactant gases into the chamber 102. A commercial embodiment of a flow control monitor suitable for the purpose is a set of digital-to-analog converters included in the model HP 3497 data acquisition system, marketed by Hewlett Packard, Palo Alto, California.

A line 108 communicates with the chamber 102 and an evacuation system (not shown), and is used to evacuate gases from the chamber 102. A pressure gauge 110 monitors the gas pressure within the reactor 102. A heater 112 is provided to heat the substrate 103 disposed within the chamber 102, with a temperature control 114 adjusting the operation of the heater. The substrate 103 is the main substrate on which the desired film is to be deposited.

An ellipsometer comprising generally a laser head 122 and a sensor head 120 is cooperatively arranged with the quartz windows 124 and 126 formed in the top plate 128 of the chamber 102 to generate a laser beam by laser head 122 which is reflected from the witness wafer 158 into the sensor head 120. The witness wafer 158 in this example is a two-inch diameter silicon or chrome-coated glass wafer having a thickness of 0.254 mm (.01 inches) or more.

A plurality of U.V. lamps 130 are provided to selectively illuminate the interior of the chamber 102 through shutter 129.

A computer 132 is coupled to the flow control monitor 116, the temperature control 114, the ellipsometer sensor head 120 and pressure gauge 110. A printer 132A and memory 132B are coupled to the computer 132 to provide a means for communicating with a human operator. In this embodiment, the HP 9845B model computer marketed by Hewlett Packard is suitable for the purpose. The computer 132 monitors and controls the flow of gas into the deposition chamber 102, the operation of the heater 112, and further monitors the reactor pressure, the substrate temperature and the ellipsometer sensor 120.

The ellipsometer is an optical instrument which can measure the thickness and refractive index of transparent films deposited on substrates of known optical properties. It can also measure the refractive index (both the real and imaginary part) of an unknown polished substrate. The ellipsometer employed in this embodiment is the model El III ellipsometer, marketed by Rudolph Instruments, Inc., Fairfield, New Jersey. The ellipsometer projects onto the sample to be measured a beam of monochromatic light of known polarization, here a Helium-Neon laser beam. This beam is projected at a shallow angle (70° from normal). The reflected beam is directed toward a receptor containing a polarization analyzer and a sensor. The polarization of the reflected beam, after computation in the ellipsometer microprocessor (comprising sensor head 120), is translated into thickness and refractive index data. Alternatively, if the refractive index of the film is known, the ellipsometer can be programmed to compute thickness alone.

The ellipsometer should be precisely aligned, in order to give reliable results. In the preferred embodiment, the measurements are made near vacuum, and suitable windows 124 and 126 (FIG. 4) are provided in the walls of the deposition reactor 102 to pass the beam without changing its polarization. These windows 124 and 126 are located at the ends of respective narrow tubes 144 and 138 communicating with the respective walls of the deposition reactor 102, to minimize any deposition of photo-oxide on the windows. Because of the increased optical beam length, the position and stability of the two "heads" 120, 122 of the ellipsometer are important to obtaining reliable results.

In this embodiment, the ellipsometer comprises two heads. One, head 122, includes the laser and a light polarizer. The other head 120 includes the sensor and analyzer. Each head is supported by a rigid bracket having stiffening webs to provide a rigid support. In addition, each head is mounted on a platform with a horizontal rotation axis and a screw adjustment allowing at least ±2° fine adjustment. These adjustments permit ready alignment of the two heads so that the beam can be made to reflect from the stationary witness wafer and into the sensor iris.

The deposition reactor 102 is shown in further detail in FIG. 4. Here, the laser head 122 of the ellipsometer is supported by the rigid support bracket 134, to direct the laser beam 136 through the quartz window 126 and tube 138 into the reactor interior to impinge on the witness wafer 156.

The sensor and analyzer head 120 is supported on rigid bracket 142, to receive the reflected laser beam 136 through tube 144 and quartz window 124.

The laser head 122 is secured to the support bracket 134 by an adjustable mechanism which, through a screw adjustment, permits a ±2° fine adjustment in the direction of the laser beam 136 from its nominal position as shown in FIG. 3. Similarly, the sensor and analyzer head 120 is coupled to the bracket 142 by an adjustable mechanism 146 which, through a screw adjustment, permits a ±2° fine adjustment in the orientation of the sensor iris.

The windows 126 and 124 are fabricated from annealed quartz in this embodiment, and should be mounted in the respective tubes 138 and 144 so as to avoid stress on the windows in directions transverse to the ellipsometer laser beam which would lead to measurement errors. In the disclosed embodiment, the windows are bonded by epoxy to rigid steel base washers, which are pressed against an O-ring seal by a pressure nut. For example, in FIG. 4, window 126 is bonded to washer 126A, which is pressed against O-ring seal 126B by pressure translating sleeve 126D and pressure nut 126C threaded onto tube 138. Such a configuration substantially eliminates stress on the windows in directions transverse to the laser beam. The only stress applied on the windows is that caused by atmospheric pressure, in a direction parallel to the laser beam, which does not affect the ellipsometric measurements.

The witness wafer 156 is mounted on a turntable 152 for rotation about an axis. FIG. 2 illustrates the witness wafer and the turntable in cross-section. A table member 150 is secured across the interior of the reactor 102 (FIG. 4), and supports the substrate workpiece 103. The turntable 152 is mounted on a rotatable and translatable shaft 154, which is driven by two stepper motors (not shown in FIG. 2) controlled by the computer 132. The turntable 152 is fitted into an opening 153 formed in the table 150. The witness wafer 156 is positioned on the top surface of the turntable 152, and a circular frame 160 is fitted over the peripheral edge of the circular witness wafer 156. The mask 158 is in turn positioned over the witness wafer 156 and the frame 160, and is secured to the table structure 150 by threaded fasteners 165.

The frame 160 is fabricated from bronze or another low friction alloy, to permit a sliding fit between the lower surface of the mask 158 and the top surface of the frame 160 as the turntable 152 is rotated on shaft 154.

It is desirable to mask the top surface of the witness wafer 156 from the reactive gases and the UV light. The mask 158 is fabricated from stainless steel and is 1.58 mm (.062 inches) thick in this embodiment. The mask 158 is removable to allow replacement of the witness wafer. Because the mask 158 is fabricated as a rigid member, the repositioning of the mask 158 allowed by fasteners 162 and 164 is reproducible and accurate, minimizing measurement errors. An opening 166 is formed in the mask 158 to expose a small portion of the top surface of the wafer 156 to the vapor deposition. The space between the exposed surface of the wafer 156 and the mask 158 is minimized, and is about 0.127 mm (.005 inches) in the disclosed embodiment. The edges of the opening 166 formed in the mask 158 are chamfered to minimize disturbance of the gas flow and reduce edge effects from the laser beam 136 striking the exposed spot of the witness wafer.

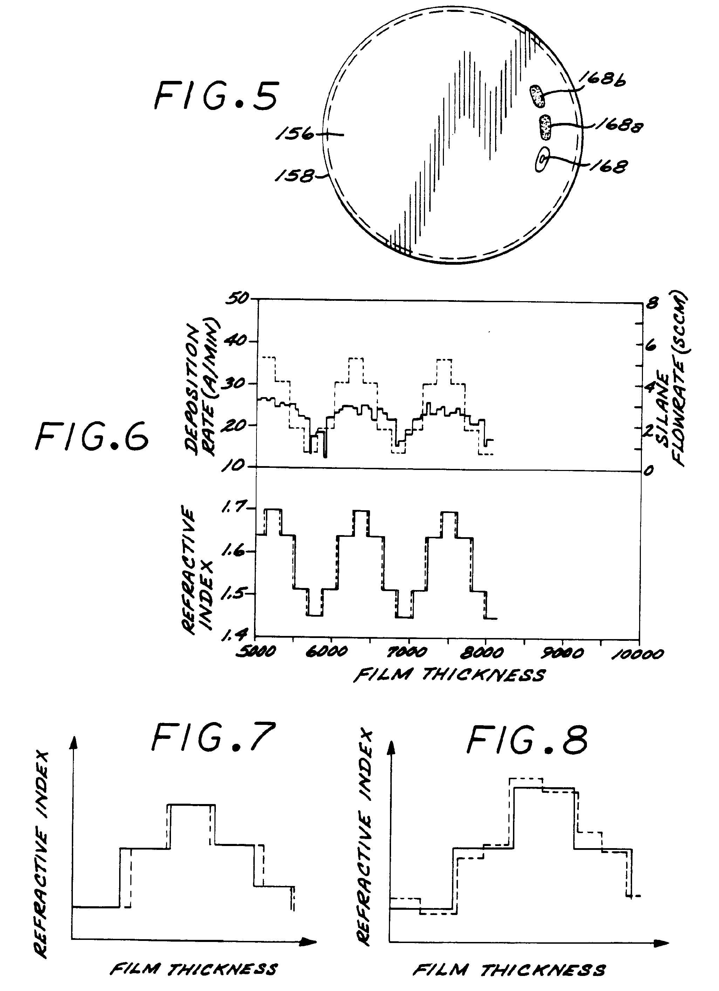

FIG. 5 is a top view of the mask 158, showing the opening 166 and the exposed underlying wafer area. The deposited area 168 on the wafer 156 is illuminated by the laser beam of the ellipsometer head 122. In this embodiment, the laser spot size is about 1.016 by 2.032 mm (.04 by .08 inches). Shown in phantom in FIG. 4 are previously deposited areas 168a and 168b, which have been rotated away from the opening 166 in the mask 158.

The disclosed embodiment has been employed to control the deposition of a film on a substrate to fabricate high-reflectance filters by sensing accelerations and decelerations in the deposition rate and adjusting the deposition time of each layer accordingly. For each deposition area 168 or "spot" on the witness wafer 156, the ellipsometer measures thickness, and the computer 132 calculates the corresponding deposition rate. Each spot 168 is measured a certain desired number of times, in this example three times, and the monitored thickness information is used by the computer 132 to predict when the layer should be completed, the wafer rotated, and the gas flow rates changed to deposit the next layer. An example is illustrated in FIG. 6 and in Table I. FIG. 6 illustrates the deposition rate, in Angstroms per minute, the intended and actual refractive index, and the reactive gas flow rate , here silane, as a function of the deposited film thickness (Angstroms). In Table I, "N" indicates the layer number, "spot" indicates the wafer spot number, "Base Film" indicates the index and thickness of the base film deposited on the substrate prior to the present layer deposition, "Sil Flow" indicates the silane gas flow rate, "I" refers to the measurement number, "N" refers to the layer index, "D" refers to the layer thickness, "Del" and "$P_{si}$" refer to the ellipsometric data, and "$D_{tot}$" refers to the total film thickness.

TABLE I

| BASE FILM | | | | | MAIN FILM | | | | | | | |
|---|---|---|---|---|---|---|---|---|---|---|---|---|
| N | Spot | Sil Nox | Dox | Flow | I | N | D | Dep Rate | Del | Psi | Dtot | Time(H:M:S) |
| | | | | | 3 | 1.450 | 182 | 16.7 | 104.25 | 30.30 | 8164 | 05:49:46 |
| 44 | 44 | 1.458 | -2 | 1.88 | 1 | 1.513 | 39 | 23.8 | 120.97 | 27.23 | 8203 | 05:51:24 |
| | | | | | 2 | 1.513 | 139 | 21.8 | 108.88 | 29.21 | 8303 | 05:56:00 |
| 45 | 45 | 1.518 | -10 | 4.18 | 1 | 1.638 | 38 | 23.0 | 122.38 | 27.40 | 8341 | 05:57:40 |
| | | | | | 2 | 1.638 | 154 | 25.1 | 108.22 | 29.41 | 8457 | 06:02:16 |
| | | | | | 3 | 1.638 | 240 | 24.7 | 99.63 | 31.04 | 8543 | 06:05:45 |
| 46 | 46 | 1.638 | -5 | 5.27 | 1 | 1.700 | 46 | 27.3 | 120.38 | 27.32 | 8589 | 06:07:27 |
| | | | | | 2 | 1.700 | 188 | 25.0 | 111.38 | 28.60 | 8661 | 06:10:19 |
| | | | | | 3 | 1.700 | 189 | 24.2 | 103.72 | 29.88 | 8732 | 06:13:15 |
| 47 | 47 | 1.700 | 14 | 4.14 | 1 | 1.637 | 50 | 30.3 | 117.30 | 27.52 | 8782 | 06:14:54 |
| | | | | | 2 | 1.637 | 121 | 24.6 | 108.63 | 28.76 | 8853 | 06:17:48 |
| | | | | | 3 | 1.637 | 192 | 24.8 | 101.30 | 30.04 | 8924 | 06:20:40 |

If the actual measured thickness for a particular layer is larger or smaller than the desired thickness, then the next layer to be deposited will be made thinner or thicker than originally planned to correct for this error. This correction is illustrated in FIG. 7 and Table II.

TABLE II

INTENDED THICKNESS

| Layer No. | Index | Original | Revised | Actual Thickness | Thickness Error |
|---|---|---|---|---|---|
| 1 | 1.45 | 200Å | 200Å | 230Å | +30Å |
| 2 | 1.56 | 200Å | 170Å | 165Å | -5Å |
| 3 | 1.61 | 200Å | 205Å | 200Å | -5Å |
| 4 | 1.57 | 200Å | 205Å | 225Å | +25Å |
| 5 | 1.50 | 200Å | 175Å | 178Å | + 3Å |

In this manner, the actual deposited refractive index profile is made to closely agree with the intended index profile, which is shown in FIG. 6. This particular deposition example yielded a narrow band, low transmittance rugate filter having 0.8% minimum transmittance, compared with 0.5% theoretical minimum transmittance.

In the example discussed above with respect to FIGS. 6 and 7, the system employed the ellipsometric measuring device to measure thickness only, given an assumed refractive index. The control system in accordance with the present invention is, however, capable of allowing control of both the refractive index and the deposited film by controlling deposition time and gas flow rates. Thus, the control system is capable of detecting not only fluctuations in deposition rate but also departures in the refractive index of the deposited material from the assumed values, and then making appropriate corrections by adjusting the gas flow accordingly. This illustrated in FIG. 8.

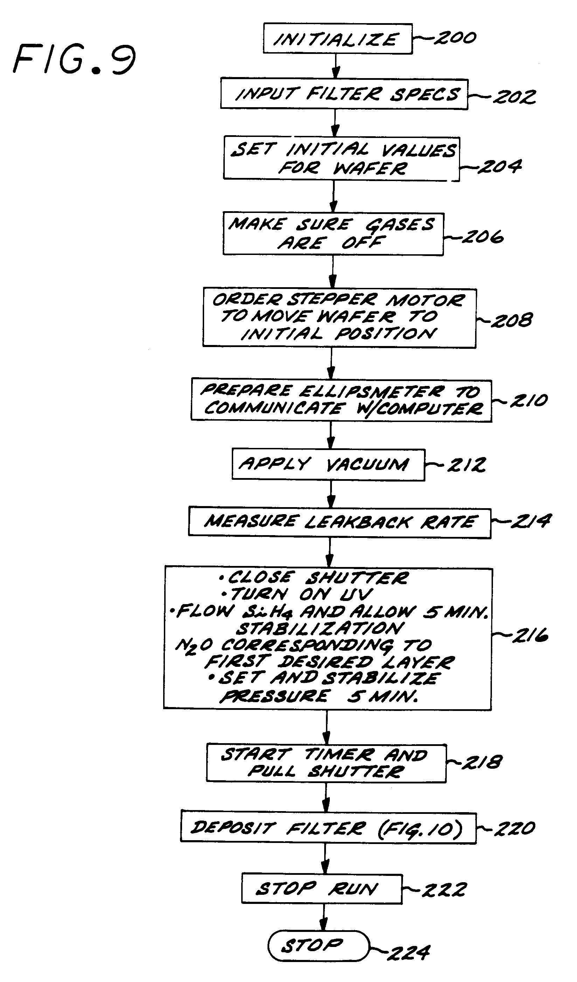

Referring now to FIG. 9, a simplified flow chart of the operation of the computer 132, determined by suitable programming, is set forth. At step 200, the computer program is initialized, and at step 202, the specifications for the optical structure, a rugate filter, for example, to be fabricated are input into the computer program, for example, by a tape or through a keyboard. These specifications comprise the maximum number of measurements per spot size on the witness wafer, the number of peaks in the rugate, the peak wavelength for each peak and the peak-to-peak index modulation for each peak, the average index, filter thickness and the number of layers in the filter.

At step 204 the initial values for the wafer are established. These initial values include such parameters as the initial silane flow rate, wafer position, refractive index of the substrate, thickness of any eventual oxide layer on the wafer, variables used in internal calculations, and the real and imaginary refractive index values for each point on the witness wafer that will be measured during the deposition. These latter refractive index values are obtained by automatically measuring for each spot on the wafer before the deposition has begun. Also, the $\Delta$ and $\Psi$ corrective factors to be used during the deposition are measured at this time.

Step 206 ensures that the reactive gas flow is turned off. At step 208, the stepper motors by which the turntable 152 is operated are ordered to move the witness wafer 156 to its initial position.

At step 210 the ellipsometer is prepared to communicate with the computer 132. At step 212, a vacuum is applied to the chamber 102 and at step 214 the leak back rate is measured. This determines the rate at which ambient gases flow into the chamber 102 when a vacuum has been applied, and indicates whether there is a leak in the system. At step 216 the UV lamp shutter 129 is closed. The UV lamps 128 are turned on, and the reactive gases are flowed to establish the appropriate pressure to be used for the first layer of the deposition process. Typically, the pressure will be allowed to stabilize for a period of approximately five minutes before the deposition process is commenced.

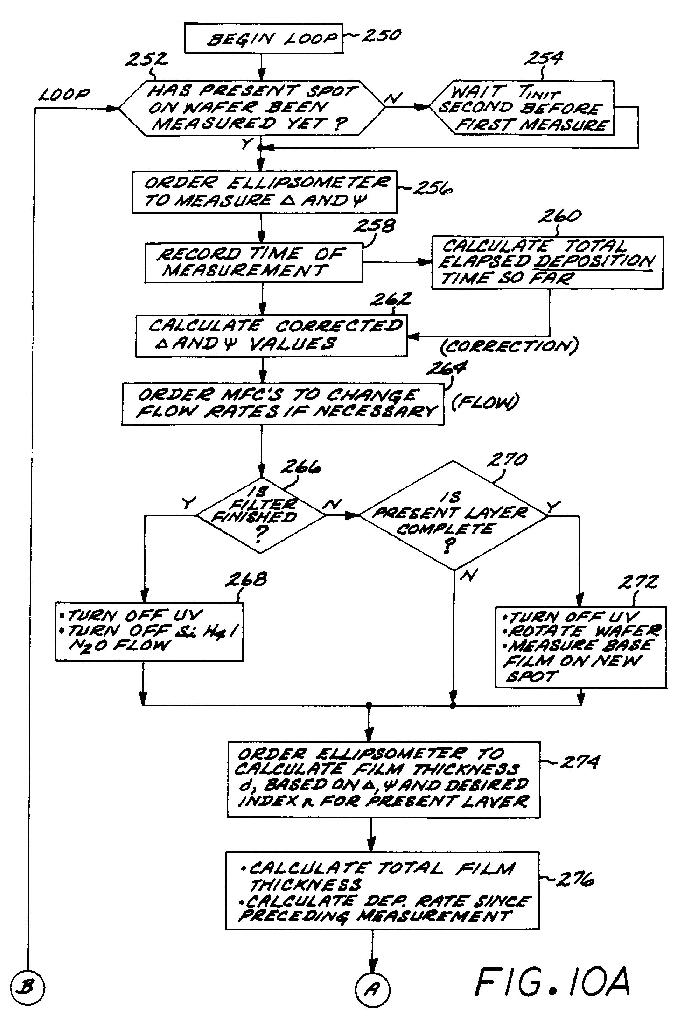

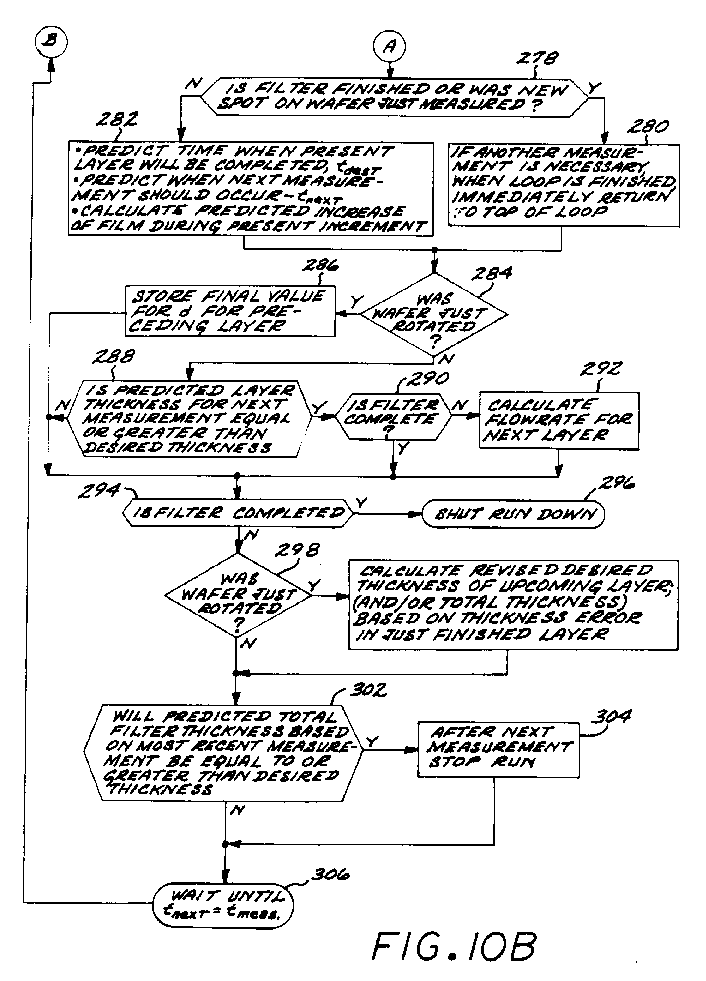

At step 218 the computer timer is initiated and the shutter 129 is opened. This illuminates the deposition chamber with UV light, activating the photo CVD deposition process. Step 220 designates the filter deposition subroutine, shown in further detail in FIGS. 10A and 10B.

At step 222, after completion of the filter, the deposition run is stopped and at 224 the program is completed.

Referring now to FIGS. 10A and 10B, the filter deposition loop is shown in further detail. The ellipsometer used in this embodiment does not give instantaneous monitoring, but requires 15-20 seconds for measuring the film at a particular spot, and another 15-20 seconds for calculating results for the current measurement. Therefore, after a measurement, the program structure outlined in FIG. 10 controls the process by predicting (based on previous data) whether or not a layer is completed, and if so, moving the witness wafer to a new spot before the results of the just-completed measurement have been calculated. The filter deposition loop begins at step 250, and at step 252 a determination is made as to whether the present spot on the witness wafer has been measured. If not, then at step 254 the system waits for a specified predetermined number of seconds before the first measurement. This time delay is referred to as "$T_{init.}$"

At step 256 the ellipsometer is ordered to measure $\Delta$ and $\Psi$, which are the two ellipsometrically measured variables, and denote the rotated angle of the ellipsometer's polarizer and analyzer. These are ellipsometer parameters used to calculate the film thickness d.

At step 258 the time of measurement is recorded and at step 260 the total elapsed deposition time thus far is calculated. At step 262 corrected values used for $\Delta$ and $\Psi$ are calculated. At step 264 the mass flow controllers are ordered to change flow rates if necessary, in response to the results of the measurement preceding the most recent one.

At step 266, it is predicted whether the filter has been completed. If not, then at step 270 another test is made to predict whether the present layer is complete. A certain answer will not be available until the results of the previous measurement have been calculated. If the answer is affirmative, then at step 272, the UV lights are turned off, the witness wafer is rotated, and the base film on the new spot is measured. If the determination at step 266 is affirmative, then at step 268 the UV lamps are turned off, the reactive gases are turned off. At step 274 the ellipsometer is finally ordered to calculate the film thickness d based upon the just measured values for $\Delta$, $\Psi$, and the desired index for the present layer. This calculation is performed using the conventional ellipsometry algorithm set forth in Equation 1:

$$\rho = \tan \Psi \exp(i\Delta), \quad (1)$$

where $\rho$ is the ratio between the complex reflection coefficients $r_p$ and $r_s$ which yield the values for film index n and film thickness d, and $\Delta$ and $\Psi$ are the ellipsometrically measured variables.

A reference describing ellipsometry and Equation 1 is the Auto-El-III Instruction Manual, Rudolph Research, 1982.

At step 276 the total film thickness and the deposition rate since the preceding measurement is calculated.

At step 278 the determination is made whether the filter is complete or whether a new spot on the wafer was just measured. If affirmative, then at step 280 if another measurement is necessary when the loop is finished, the program control will skip step 306. If the determination at 278 is negative, then at step 282, several calculations are made. A first calculation is to predict the time at which the present layer will be completed, $T_{dest}$, assuming the present deposition rate. Also at step 282, knowing $T_{dest}$ and the desired number of measurements per layer, a prediction is made as to when the next measurement should occur, $T_{next}$. Finally, at step 282 the predicted increase in the thickness of the film during the present increment, i.e., during the present monitoring period ending with the next measurement, is calculated.

At step 284 a determination is made as to whether the wafer was just rotated. If so, then the final value for the thickness d for the preceding layer is stored and the program control branches to step 294. If the determination at step 284 was negative, then at step 288 the predicted layer thickness for the next measurement is checked to determine whether it is equal to or greater than the desired thickness and if not, operation branches to step 294. If the predicted layer thickness is greater than or equal to the desired thickness, then at step 290 a determination is made as to whether the filter is completed and if so, program operation branches to step 294. If the filter is not completed, then at step 292 the flow rate for the next layer is calculated using Equation 2.

$$f_{gi} = \dot{f}_{gi}n - f_{gio} \quad (2)$$

where $f_{gi}$ = flow rate of gas i;

n = assumed refractive index of the deposited film for the present layer;

$\dot{f}_{gi}$ = the slope of the flowrate vs. refractive index function for gas i; and

$f_{gio}$ = the intercept of the flowrate vs. refractive index function with the flowrate axis for gas i.

An exemplary flowrate/refractive index function for silane gas is depicted in FIG. 1 of U.S Patent 4,545,646.

At step 294 a determination is made as to whether the filter is completed and if affirmative, then the run is shut down at step 294 and operation of the filter loop returns to the main program (FIG. 9). If the filter is not completed, then at step 298 a determination is made as to whether the wafer was just rotated. If yes, then at step 300 the program calculates the revised desired thickness of the next layer $d_{next}$ (and/or the total thickness) based on the thickness error in the just completed layer, using Equation 3.

$$d_{next} = d_{next\,o} + (n/n_{next})(d_{desired} - d_{actual}) \quad (3)$$

where, $d_{next\,o}$ = initial prediction of desired thickness for the next layer;

$n_{next}$ = assumed refractive index for the present layer; and

$d_{desired}$ = desired thickness for the present layer.

At step 302 the program determines whether the predicted total filter thickness based on the most recent measurement will be greater than or equal to the desired thickness. If the determination is affirmative, then after the next measurement, the run is stopped at step 304. If the answer is negative, then at step 306 a delay occurs until the time $T_{next}$ equals $T_{meas}$. The program operation then loop back to step 252.

The flowchart shown in FIGS. 9, 10A and 10B assumes that only the thickness d is measured by the ellipsometer, instead of both the thickness and refractive index. Also, the flowchart assumes that a certain minimum thickness of film must be deposited before the ellipsometer provides accurate readings, and that the ellipsometer requires non-negligible amounts of time ($t_{meas}$) to measure and to calculate.

It is understood that the above-described embodiment is merely illustrative of the possible specific embodiments which may represent principles of the present invention. Other arrangements may readily be devised in accordance with these principles by those skilled in the art without departing from the scope of the invention.

**Claims**

1. A system (100) for automated control of the deposition of a film onto a substrate, comprising:

a deposition reactor (102);

means for depositing a given material or materials on one or more substrates (103) disposed within said reactor in dependence on one or more deposition control variables;

means for measuring the thickness of the film as it is deposited, said means comprising;

(i) a witness wafer (156) disposed in said reactor;

(ii) an ellipsometric measuring device for successively measuring the thickness of the film as it is being deposited on said wafer in real time and without removing said wafer from the deposition reactor and without disturbing said depositing means; and

(iii) means for providing a film thickness signal indicative of the film thickness;

central controller for automated control of said depositing means and said measuring means, said controller comprising means responsive to said film thickness signal for determining the thickness of the film and means for controlling said deposition control variables to effectively control said depositing means;

characterised in that:

said measuring means further comprises a witness wafer mask (158) arranged to mask the top surface of said witness wafer from the material deposition, said mask having an opening (166) formed therein, and means for moving said witness wafer in response to wafer movement commands from said central controller so as sequentially to expose non-deposited areas of said wafer surface; and

said controller further comprises means for providing said wafer movement commands so as freshly to expose a non-deposited area on said witness wafer when the thickness of the film layer on the wafer area presently exposed to the deposition process exceeds a predetermined film layer thickness.

2. A system according to claim 1 wherein said ellipsometric measuring device comprises means (122) for directing a laser beam onto the surface of said witness wafer (158) and a sensor (120) disposed to receive the laser beam after its reflection from the surface of said witness wafer.

3. A system according to claim 2 wherein said means for directing a laser beam comprises a laser mounted externally with respect to the deposition reactor for generating said laser beam, a first quartz window (124) in a first wall of said reactor for admitting said laser beam into said reactor, and means for mounting said first quartz window in or adjacent said first reactor wall for minimizing stress forces on said window transverse to said laser beam, and wherein said sensor is mounted externally with respect to said reactor, and further comprising a second quartz window (126) in a second wall of said reactor for passing said reflected laser beam from the deposition reactor to said externally mounted sensor, and means for mounting said second quartz window in or adjacent said second reactor wall so as to minimize stress forces on said window transverse to said laser beam, whereby ellipsometric errors resulting from stress on said windows are minimized.

4. A system according to any one of claims 1 to 3, wherein said means for moving said wafer comprises a turntable (152) and means for rotating said turntable, said witness wafer being mounted on said turntable.

5. A system according to claim 4, wherein said means for rotating said turntable comprises a stepper motor controlled by said central controller for incremental rotational movements in response to commands from said central controller.

6. A system according to any one of claims 1 to 5, wherein said means for depositing a given material or materials comprises a photochemical vapor deposition system, wherein said deposition control variables include means for selectively admitting one or more reactant gases into said deposition chamber, and means for selectively illuminating said chamber with light of a predetermined wavelength range.

7. A system according to claim 6 wherein said means for selectively admitting reactant gases into said chamber comprises a mass flow controller coupling a source of a given reactant gas to said chamber.

8. A system according to claim 6 or claim 7, wherein said depositing means comprises a means for depositing a film having a gradient refractive index profile as a function of film thickness, and said system is for automated control of a film having an arbitrary refractive index profile.

9. A system according to any one of Claims 1 to 8, wherein said central controller comprises means for storing the desired specifications of the film to be deposited on said substrate.

10. A system according to any one of claims 6 to 9, wherein said controller comprises means for controlling said gas admitting means and said illuminating means to control the rate of deposition.


**Patentansprüche**

1. Ein System (100) zur automatisierten Kontrolle der Deposition einer Schicht auf ein Substrat, mit:
    einem Depositionsreaktor (102);
    einem Mittel zur Deposition eines gegebenen Materials oder Materialien auf ein oder mehrere Substrate (103), welche innerhalb des Reaktors angeordnet sind, in Abhängigkeit einer oder mehrerer Depositionssteuervariablen;
    einem Mittel zum Messen der Dicke der Schicht wie sie abgelagert worden ist, wobei das Mittel
    (i) eine Hilfswafer (156), welche in dem Reaktor angeordnet ist;
    (ii) ein ellipsometrisches Meßbauteil zum sukzessiven Messen der Dicke der Schicht, wie sie auf der Wafer abgelagert wird, in Realzeit und ohne Entfernen der Wafer aus dem Depositionsreaktor und ohne die Depositionsmittel zu stören; und
    (iii) Mittel zum Bereitstellen eines Schichtdickensignals, welches die Schichtdicke anzeigt, aufweist;
    einem Zentralkontroller für automatisierte Kontrolle der Depositionsmittel und der Meßmittel, wobei der Kontroller Mittel aufweist, welche auf das Schichtdickensignal zur Bestimmung der Dicke der Schicht ansprechen, und Mittel zur Steuerung der Depositionskontrollvariablen zur effektiven Kontrolle der Depositionsmittel;

dadurch gekennzeichnet, daß:

das Meßmittel desweiteren eine Hilfswafermaske (158) aufweist, welche angeordnet ist, um die obere Oberfläche der Hilfswafer von der Materialdeposition zu maskieren, wobei die Maske eine Öffnung (166) aufweist, welche darin gebildet ist, und Mittel zum Bewegen der Hilfswafer als Antwort auf Waferbewegungskommandos von dem Zentralkontroller, um nicht abgelagerte Gebiete der Waferoberfläche folgend auszusetzen; und

der Kontroller desweiteren Mittel zum Bereitstellen der Waferbewegungskommandos aufweist, um zusätzlich ein nicht abgelagertes Gebiet auf der Hilfswafer auszusetzen, wenn die Dicke der Filmschicht auf dem Wafergebiet, welche gegenwärtig dem Depositionsverfahren ausgesetzt ist, eine vorherbestimmte Schichtdicke überschreitet.

2. Ein System nach Anspruch 1, worin die ellipsometrische Meßvorrichtung Mittel (122) zum Richten eines Laserstrahls auf die Oberfläche der Hilfswafer (158) und einen Sensor (120) aufweist, welcher angeordnet ist, um den Laserstrahl nach seiner Reflektion von der Oberfläche der Hilfswafer zu empfangen.

3. Ein System nach Anspruch 2, worin das Mittel zum Richten eines Laserstrahls einen Laser aufweist, welcher extern hinsichtlich des Depositionsreaktors zur Erzeugung des Laserstrahls angebracht ist, ein erstes Quarzfenster (124) in einer ersten Wand des Reaktors zum Aufnehmen des Laserstrahls in den Reaktor, und Mittel zum Anbringen des ersten Quarzfensters in oder benachbart der ersten Reaktorwand zum Minimieren von Druckkräften auf das Fensterquerstück zu dem Laserstrahl, und worin der Sensor extern hinsichtlich des Reaktors angebracht worden ist, und welches desweiteren ein zweites Quarzfenster (126) in einer zweiten Wand des Reaktors zum Durchlassen des reflektierten Laserstrahls von dem Depositionsreaktor zu dem extern angebrachten Sensor, und Mittel zum Anbringen des zweiten Quarzfensters in oder benachbart der zweiten Reaktorwand, um Druckkräfte auf das Fensterquerstück zu dem Laserstrahl zu minimieren, aufweist, wodurch ellipsometrische Fehler minimiert werden, welche aus dem Druck auf die Fenster resultieren.

4. Ein System nach irgendeinem der Ansprüche 1 bis 3, worin das Mittel zum Bewegen der Wafer eine Drehscheibe (152) und Mittel zum Drehen der Drehscheibe aufweist, wobei die Hilfswafer auf der Drehscheibe angebracht ist.

5. Ein System nach Anspruch 4, worin das Mittel zum Drehen der Drehscheibe einen Schrittmotor aufweist, welcher durch den Zentralkontroller für inkrementelle Rotationsbewegungen gesteuert wird als Antwort auf die Kommandos von dem Zentralkontroller.

6. Ein System nach irgendeinem der Ansprüche 1 bis 5, worin das Mittel zur Deposition eines gegebenen Materials oder Materialien ein photochemisches Aufdampfungssystem aufweist, worin die Depositionsteuervariablen Mittel zum selektiven Aufnehmen eines oder mehrerer Reaktanzgase in die Depositionskammer, und Mittel zum selektiven Illuminieren der Kammer mit Licht eines vorherbestimmten Wellenlängenbereichs beinhalten.

7. Ein System nach Anspruch 6, worin das Mittel zum selektiven Aufnehmen der Reaktanzgase in die Kammer einen Massenflußkontroller aufweist, welcher eine Quelle eines gegebenen Reaktanzgases in die Kammer koppelt.

8. Ein System nach Anspruch 6 oder 7, worin das Depositionsmittel ein Mittel zum Ablagern einer Schicht aufweist, welche ein Gradientenbrechungszahlprofil als Funktion der Schichtdicke besitzt, und das System der automatischen Kontrolle einer Schicht dient, welche ein willkürliches Brechungszahlprofil besitzt.

9. Ein System nach irgendeinem der Ansprüche 1 bis 8, worin der Zentralkontroller Mittel zum Speichern der gewünschten Spezifikationen der Schicht aufweist, welche auf dem Substrat abgelagert werden soll.

10. Ein System nach irgendeinem der Ansprüche 6 bis 9, worin der Kontroller Mittel zum Steuern des Gasaufnehmmittels und der Illuminationsmittel aufweist, um die Rate der Deposition zu steuern.

**Revendications**

1. Un système (100) pour la commande automatisée du dépôt d'une pellicule sur un substrat, comprenant :
   un réacteur de dépôt (102);
   des moyens pour déposer un matériau ou des matériaux donnés sur un ou plusieurs substrats (103) disposés à l'intérieur du réacteur, sous la dépendance d'une ou de plusieurs variables de commande de dépôt;
   des moyens pour mesurer l'épaisseur de la pellicule au fur et à mesure qu'elle est déposée, ces moyens comprenant;
   (i) une tranche témoin (156) disposée dans le réacteur;
   (ii) un dispositif de mesure ellipsométrique pour mesurer successivement l'épaisseur de la pellicule au fur et à mesure qu'elle est déposée sur la tranche, en temps réel, et sans retirer la tranche du réacteur de dépôt ni perturber les moyens de dépôt; et
   (iii) des moyens destinés à produire un signal d'épaisseur de pellicule indiquant l'épaisseur de la pellicule;
   un dispositif de commande central pour la commande automatisée des moyens de dépôt et des moyens de mesure, ce dispositif de commande comprenant des moyens qui réagissent au signal d'épaisseur de pellicule en déterminant l'épaisseur de la pellicule, et des moyens qui sont destinés à commander les variables de commande de dépôt précitées pour commander effectivement les moyens de dépôt;
   caractérisé en ce que :
   les moyens de mesure comprennent en outre un masque de tranche témoin (158) qui est conçu pour masquer la surface supérieure de la tranche témoin vis-à-vis du dépôt de matériau, ce masque ayant une ouverture (166) formée à l'intérieur, et des moyens pour déplacer la tranche témoin sous la dépendance d'ordres de mouvement de tranche qui proviennent du dispositif de commande central, afin d'exposer séquentiellement des régions de la surface de la tranche qui n'ont pas reçu de dépôt; et
   le dispositif de commande comprend en outre des moyens qui sont destinés à produire les ordres de mouvement de la tranche de façon à exposer nouvellement une région de la tranche témoin qui n'a pas reçu de dépôt, lorsque l'épaisseur de la couche de pellicule sur la région de la tranche qui est exposée présentement au processus de dépôt dépasse une épaisseur de couche de pellicule prédéterminée.

2. Un système selon la revendication 1, dans lequel le dispositif de mesure ellipsométrique comprend des moyens (122) qui sont destinés à diriger un faisceau laser sur la surface de la tranche témoin (158), et un capteur (120) qui est disposé de façon à recevoir le faisceau laser après sa réflexion sur la surface de la tranche témoin.

3. Un système selon la revendication 2, dans lequel les moyens qui sont destinés à diriger un faisceau laser comprennent un laser monté extérieurement au réacteur de dépôt, pour générer le faisceau laser précité, une première fenêtre en quartz (124) dans une première paroi du réacteur, pour admettre le faisceau laser dans le réacteur, et des moyens qui sont conçus pour monter la première fenêtre en quartz dans la première paroi du réacteur ou en position adjacente à celle-ci, afin de minimiser des forces de contraintes s'exerçant sur la fenêtre transversalement au faisceau laser, et dans lequel le capteur est monté extérieurement au réacteur, et comprenant en outre une seconde fenêtre en quartz (126) dans une seconde paroi du réacteur, pour transmettre le faisceau laser réfléchi, du réacteur de dépôt vers le capteur monté extérieurement, et des moyens qui sont destinés à monter la seconde fenêtre en quartz dans la seconde paroi du réacteur, ou en position adjacente à celle-ci, afin de minimiser des forces de contraintes s'exerçant sur la fenêtre transversalement au faisceau laser, ce qui permet de minimiser des erreurs ellipsométriques qui résultent des contraintes s'exerçant sur les fenêtres.

4. Un système selon l'une quelconque des revendications 1 à 3, dans lequel les moyens destinés à déplacer la tranche comprennent un plateau tournant (152) et des moyens pour faire tourner ce plateau tournant, la tranche témoin étant montée sur le plateau tournant.

5. Un système selon la revendication 4, dans lequel les moyens destinés à faire tourner le plateau tournant comprennent un moteur pas à pas qui est commandé par le dispositif de commande central, de façon à effectuer des mouvements de rotation incrémentiels sous l'effet d'ordres provenant du dispositif de commande central.

6. Un système selon l'une quelconque des revendications 1 à 5, dans lequel les moyens destinés à déposer

11

un matériau ou des matériaux donnés consistent en un système de dépôt photochimique en phase vapeur, dans lequel les variables de commande de dépôt précitées sont associées à des moyens permettant d'admettre sélectivement un ou plusieurs gaz réactifs dans la chambre de dépôt, et à des moyens permettant d'illuminer sélectivement cette chambre avec de la lumière d'une gamme de longueurs d'onde prédéterminée.

7. Un système selon la revendication 6, dans lequel les moyens permettant d'admettre sélectivement des gaz réactifs dans la chambre comprennent un régulateur de débit-masse qui fait communiquer une source d'un gaz réactif donné avec la chambre.

8. Un système selon selon la revendication 6 ou la revendication 7, dans lequel les moyens de dépôt comprennent des moyens qui sont destinés à déposer une pellicule présentant un gradient de profil d'indice de réfraction en fonction de l'épaisseur de la pellicule, et le système précité est prévu pour la commande automatisée d'une pellicule ayant un profil d'indice de réfraction arbitraire.

9. Un système selon l'une quelconque des revendications 1 à 8, dans lequel le dispositif de commande central comprend des moyens qui sont conçus pour mémoriser les spécifications désirées de la pellicule à déposer sur le substrat.

10. Un système selon l'une quelconque des revendications 6 à 9, dans lequel le dispositif de commande comprend des moyens qui sont destinés à commander les moyens d'admission de gaz et les moyens d'illumination pour commander la vitesse de dépôt.

EP 0 339 845 B1

100

132

COMPUTER

PRINTER

FLOPPY DISC MEMORY
132B

132A

116

FLOW CONTROL MONITOR

120

128

122

126

124

110

103

102

104

150

152

108

EVACUATION SYSTEM
111

MFC 1

MFC 2

MFC N

TEMPERATURE CONTROL

106

105

107

109

114

FIG. 1

FIG.2

FIG.3

REFRACTIVE INDEX

FILM THICKNESS

FIG.4

*FIG.5*

*FIG.6*

DEPOSITION RATE (Å/MIN)

SILANE FLOWRATE (SCCM)

REFRACTIVE INDEX

FILM THICKNESS

*FIG.7*

*FIG.8*

REFRACTIVE INDEX

FILM THICKNESS

REFRACTIVE INDEX

FILM THICKNESS

15

FIG.9

INITIALIZE —200

INPUT FILTER SPECS —202

SET INITIAL VALUES FOR WAFER —204

MAKE SURE GASES ARE OFF —206

ORDER STEPPER MOTOR TO MOVE WAFER TO INITIAL POSITION —208

PREPARE ELLIPSMETER TO COMMUNICATE W/COMPUTER —210

APPLY VACUUM —212

MEASURE LEAKBACK RATE —214

· CLOSE SHUTTER
· TURN ON UV
· FLOW $SiH_4$ AND ALLOW 5 MIN. STABILIZATION
$N_2O$ CORRESPONDING TO FIRST DESIRED LAYER
· SET AND STABILIZE PRESSURE 5 MIN.
—216

START TIMER AND PULL SHUTTER —218

DEPOSIT FILTER (FIG.10) —220

STOP RUN —222

STOP —224

BEGIN LOOP ~250

LOOP

252

HAS PRESENT SPOT ON WAFER BEEN MEASURED YET ? → N → WAIT $T_{INIT}$ SECOND BEFORE FIRST MEASURE ~254

Y

ORDER ELLIPSOMETER TO MEASURE Δ AND Ψ ~256

RECORD TIME OF MEASUREMENT ~258 → CALCULATE TOTAL ELAPSED DEPOSITION TIME SO FAR ~260

CALCULATE CORRECTED Δ AND Ψ VALUES ~262 ← (CORRECTION)

ORDER MFC'S TO CHANGE FLOW RATES IF NECESSARY ~264 (FLOW)

266 IS FILTER FINISHED ? 

Y

270 IS PRESENT LAYER COMPLETE ?

N ← → N

Y

• TURN OFF UV
• TURN OFF $Si H_4$/ $N_2O$ FLOW ~268

• TURN OFF UV
• ROTATE WAFER
• MEASURE BASE FILM ON NEW SPOT ~272

ORDER ELLIPSOMETER TO CALCULATE FILM THICKNESS d, BASED ON Δ, Ψ AND DESIRED INDEX $n$ FOR PRESENT LAYER ~274

• CALCULATE TOTAL FILM THICKNESS
• CALCULATE DEP. RATE SINCE PRECEDING MEASUREMENT ~276

B

A

FIG.10A

EP 0 339 845 B1

Ⓑ

Ⓐ

278

N ─ IS FILTER FINISHED OR WAS NEW SPOT ON WAFER JUST MEASURED ? ─ Y

282
- PREDICT TIME WHEN PRESENT LAYER WILL BE COMPLETED, $t_{dest}$
- PREDICT WHEN NEXT MEASUREMENT SHOULD OCCUR — $t_{next}$
- CALCULATE PREDICTED INCREASE OF FILM DURING PRESENT INCREMENT

280
IF ANOTHER MEASUREMENT IS NECESSARY, WHEN LOOP IS FINISHED, IMMEDIATELY RETURN TO TOP OF LOOP

286
STORE FINAL VALUE FOR d FOR PRECEDING LAYER

284
Y ─ WAS WAFER JUST ROTATED ? ─ N

288
N ─ IS PREDICTED LAYER THICKNESS FOR NEXT MEASUREMENT EQUAL OR GREATER THAN DESIRED THICKNESS ─ Y

290
IS FILTER COMPLETE ? ─ N

292
CALCULATE FLOWRATE FOR NEXT LAYER

294
IS FILTER COMPLETED ─ Y

296
SHUT RUN DOWN

N

298
WAS WAFER JUST ROTATED ? ─ Y

CALCULATE REVISED DESIRED THICKNESS OF UPCOMING LAYER; (AND/OR TOTAL THICKNESS) BASED ON THICKNESS ERROR IN JUST FINISHED LAYER

N

302
WILL PREDICTED TOTAL FILTER THICKNESS BASED ON MOST RECENT MEASUREMENT BE EQUAL TO OR GREATER THAN DESIRED THICKNESS ─ Y

304
AFTER NEXT MEASUREMENT STOP RUN

N

306
WAIT UNTIL $t_{next} = t_{meas.}$

FIG.10B

18